# EUROPÄISCHE PATENTSCHRIFT

(11) **EP 2 948 261 B1**
(45) Veröffentlichungstag und Bekanntmachung des Hinweises auf die Patenterteilung: **26.08.2020**
(21) Anmeldenummer: 14707335.7
(22) Anmeldetag: 23.01.2014
(51) Int. Cl.: B22F 1/00, C22C 1/05, C22C 29/16, C22C 32/00, C22C 30/00, B22F 5/02

(54) **VERFAHREN ZUR HERSTELLUNG VON CHROMNITRID-HALTIGEN SPRITZPULVERN, CHROMNITRID-HALTIGE SPRITZPULVER, VERFAHREN ZUM THERMISCHEN SPRITZEN EINES BAUTEILS MITTELS GENANNTER SPRITZPULVER, UND VERWENDUNG DES GENANNTEN SPRITZPULVERS ZUR OBERFLÄCHENBESCHICHTUNG VON BAUTEILEN**
METHOD FOR PRODUCING SPRAY POWDERS CONTAINING CHROMIUM NITRIDE, SPRAY POWDERS CONTAINING CHROMIUM NITRIDE, METHOD OF THERMAL SPRAYING A COMPONENT USING SAID SPRAY POWDERS, AND USE OF SAID SPRAY POWDERS FOR COATING A COMPONENT
PROCÉDÉ DE FABRICATION DE POUDRES POUR PULVÉRISATION CONTENANT DU NITRURE DE CHROME, POUDRES POUR PULVÉRISATION CONTENANT DU NITRURE DE CHROME, PROCÉDÉ DE PULVÉRISATION À CHAUD DE COMPOSANTS UTILISANT LESDITES POUDRES, ET UTILISATION DE CES POUDRES POUR PULVÉRISATION POUR REVÊTIR DES COMPOSANTS

(30) Priorität: 24.01.2013 DE 102013201104; 25.01.2013 US 201361756475 P
(43) Veröffentlichungstag der Anmeldung: 02.12.2015
(73) Patentinhaber: Höganäs Germany GmbH, 38642 Goslar (DE)
(72) Erfinder: GRIES, Benno, 38302 Wolfenbüttel (DE); BRUENING, Bernhard, 38667 Bad Harzburg (DE)
(74) Vertreter: Hoffmann Eitle
(86) Internationale Anmeldenummer: PCT/EP2014/051324
(87) Internationale Veröffentlichungsnummer: WO 2014/114714

(56) Entgegenhaltungen:
- EP-A1- 1 564 309
- DE-B3-102008 056 720
- US-A- 4 623 402
- US-A1- 2004 037 969
- US-A1- 2011 076 587
- US-A1- 2012 082 586

## Beschreibung

Die vorliegende Erfindung betrifft ein Verfahren zur Herstellung Chromnitrid-haltiger gesinterter Spritzpulver. Derartige gesinterte Spritzpulver können zur Beschichtung von Verschleißteilen, Konstruktionsbauteilen oder Werkzeugen durch thermisches Spritzen verwendet werden. Insbesondere kann das mittels des erfindungsgemäßen Verfahren hergestellte Spritzpulver zur Oberflächenbeschichtung von Verschleißteilen, Konstruktionsbauteilen und Werkzeugen bei stark beanspruchten Reibpaarungen verwendet werden, wenn diese Reibpaarungen zur Reib- oder Mikroverschweißung neigen, beispielsweise bei Verbrennungskraftmaschinen, Kolbenverdichtern oder Kolbenmaschinen oder Kolbenstangen.

Verschleiß ist vielfach lebensdauerbestimmend. Optimierungen innerhalb eines tribologischen Systems wirken sich daher für die Anwender direkt lebensdauererhöhend und somit kostensenkend aus. Entsprechende Bauteile werden mit Beschichtungen versehen, um die tribologischen- und Verschleißeigenschaften zu verbessern. Beschichtungen zeichnen sich - analog zu Massivwerkstoffen - durch verschiedene und empirisch ermittelbare Eigenschaften aus. Dazu zählen beispielsweise Härte, Verschleißbeständigkeit und Korrosionsverhalten in verschiedenen Medien. In vielen Anwendungsfällen spielt jedoch das Reibverhalten von Beschichtungen gegenüber einem zweiten Reibpartner eine besondere Rolle. Dies sind beispielsweise beschichtete Kolbenstangen, welche in einer Führungshülse aus Stahl oder Gusseisen laufen. Von herausragender Bedeutung ist das Verhalten der Reibpaarung "Beschichtung/Reibpartner" beispielsweise bei Verbrennungskraftmaschinen, wo beschichtete Kolbenringe in einer Buchse aus beispielsweise Grauguss oder AlSi-Legierungen laufen. Insbesondere bei solchen Anwendungen hat sich CrN als besonders geeignet herausgestellt. Beschichtungen aus CrN oder dieses enthaltende werden daher in großem Umfang über PVD (Physical Vapor Deposition) auf Kolbenringe für Verbrennungskraftmaschinen, Kolbenverdichter und ähnlichen Kolbenmaschinen, aber auch auf Extruderschnecken und ähnliche Bauteile aufgebracht. Derartige Schichten erlauben hohe Laufleistungen bei minimalem Verschleiß und sind mittlerweile im Kraftfahrzeugbereich weit etabliert. Nachteilig ist jedoch ein hoher Kapitalbedarf für die Anlagentechnik, was nur bei hohen Stückzahlen und kleindimensionierten Bauteilen wirtschaftlich ist. Für größer dimensionierte Bauteile oder dickere Schichten kann CrN mittels PVD bislang nicht wirtschaftlich aufgebracht werden. Zudem bauen sich in PVD-Schichten mit zunehmender Schichtdicke Spannungen auf, deren Ursache in den unterschiedlichen thermischen Ausdehnungskoeffizienten von Substrat und Schichtwerkstoff zu finden ist. Solche Spannungen führen zu Rissbildung bis hin zur Schichtablösung. Das hat zur Folge, dass für viele Anwendungen in stark beanspruchten Reibpaarungen aufgrund von zu niedriger Schichtdicke nicht genug Verschleißreserven vorliegen. Mittels PVD hergestellte Beschichtungen weisen niedrige Rauhigkeiten von unter 10 µm auf, was für Reibpaarungen sehr vorteilhaft ist. Als Alternative für PVD bietet sich das thermische Spritzen an. Thermische Spritzpulver werden zur Herstellung von Beschichtungen auf Substraten eingesetzt. Dabei werden pulverförmige Partikel in eine Verbrennungs- oder Plasmaflamme eingebracht, welche auf das (meistens metallische) Substrat gerichtet ist, das beschichtet werden soll. Dabei schmelzen die Partikel in der Flamme ganz oder teilweise auf, prallen auf das Substrat, erstarren dort und bilden in Form von erstarrten "Splats" die Beschichtung. Durch thermisches Spritzen hergestellte Beschichtungen können bis zu mehreren 100 µm Schichtdicke aufweisen und bestehen oftmals aus einer oder mehreren zumeist keramischen und/oder metallischen Komponente(n). Dabei ist die metallische Komponente in der Lage, thermisch induzierte Schichteigenspannungen durch plastisches Fließen abzubauen, wohingegen die keramische Hartphase das notwendige Verschleißverhalten der Schicht einstellt. Zudem weisen thermisch gespritzte Schichten oft Porositäten auf, was für den Abbau von Spannungen günstig ist.

Verschleißoberflächen mit tribologisch eingestellten Reibpaarungen, insbesondere Kolbenringe und -stangen, werden großtechnisch mit thermischen Spritzpulvern auf Molybdänkarbid- oder Chromkarbid-Basis in Kombination mit Metallen und Legierungen, wie Nickel, Molybdän, Nickelchrom, thermisch beschichtet ("thermisches Spritzen"). Hiermit lassen sich Schichten von bis zu einigen 100 µm Dicke herstellen. Derartige Schichten und die verwendeten Spritzpulver bestehen aus je mindestens einer metallischen Komponente (z.B. NiCrBSi-Legierung, Molybdän) und einem Härteträger, welcher den Verschleiß des Kolbenrings moduliert (z.B. Chrom- und/oder Molybdänkarbide).

Die Eigenhärte dieser Härteträger darf jedoch nicht zu hoch sein, da sonst die Zylinderlaufbahn zerspant wird. Daher werden Hartstoffe mit hoher Eigenhärte, wie Titan- oder Wolframkarbid, nicht verwendet. Verwendet werden üblicherweise Karbide als Härteträger, welche weniger als 2000 HV Eigenhärte aufweisen, wie Cr- und Mo-Karbide. Letzeres hat eine Eigenhärte von 1900 HV (Mo₂C). Vorzugsweise ist die Partikelgröße dieser Härteträger möglichst klein, damit sie die Zylinderlaufbahn polieren und nicht zerspanen. Dies betrifft auch eventuell zusätzlich vorhandene Oxide, wie z.B. Chrom- oder Aluminiumoxid.

Thermische Spritzpulver mit Härteträgern können auf verschiedene Arten hergestellt werden.

Agglomerierte und nachfolgend in sich gesinterte Spritzpulver werden hergestellt, indem pulverförmige Härteträger sowie metallische Bindelegierungen in Pulverform (beispielsweise Ni- oder Ni-Basislegierungspulver) in einer Flüssigkeit dispergiert werden und danach durch Flüssigkeitsabtrennung ein Granulationsschritt durchgeführt wird, beispielsweise mittels Sprühtrocknung. Erhalten werden Partikel, die aus einer agglomerierten Mischung der verwendeten Pulver bestehen. Diese Agglomerate haben eine mechanische Festigkeit, welche typischerweise für moderne Spritzverfahren, wie HVOF ("High Velocity Oxygen Fuel") nicht geeignet ist, da diese aufgrund der hohen Flammengeschwindigkeiten mechanisch stabile Agglomerate erfordern. Nachfolgend wird das Sprühgranulat gegebenenfalls klassiert und in einem folgenden thermischen Verfahrensschritt soweit in sich versintert, dass das Granulat eine mechanische Festigkeit aufweist, welche ausreichend ist, dass es während des thermischen Spritzprozesses, z.B. mittels HVOF, nicht zerfällt. Der thermische Verfahrensschritt ("Sinterung") wird üblicherweise entweder im Vakuum oder unter einem eine Oxidation vermeidenden Schutzgas in der Nähe des Normaldrucks durchgeführt, meistens Wasserstoff, ggf. mit Anteilen an Argon und/oder anderen Edelgasen. Erhalten wird ein Pulver oder ein locker versinterter Kuchen, der leicht wieder in Pulver - in diesem Fall das Spritzpulver - zu überführen ist. Die erhaltenen Pulver ähneln in Größe und Aussehen dem Sprühgranulat. Dieses in sich gesinterte Agglomerat wird nun als "gesintertes Agglomerat" bezeichnet. Man spricht daher industrieüblich von "agglomeriert/gesinterten Spritzpulvern" sowie von "agglomeriert/gesinterten Pulvern". Die typische innere Struktur solcher agglomeriert/gesinterten Spritzpulver ist aus Bild A.1 der DIN EN 1274 (Februar 2005) ersichtlich. Man erkennt deutlich die beiden Pulverkomponenten (Hartstoff und metallische Matrix). Agglomeriert/gesinterte Spritzpulver sind besonders vorteilhaft, da sie große Freiheit in der Wahl der Komponenten bieten (beispielsweise deren Gehalte und Partikelgrößen) und sich aufgrund ihrer guten Fließfähigkeit im Spritzprozess gut dosieren lassen. Insbesondere lassen sich sehr feinteilige Härteträger verwenden, was im Einsatz zu sehr glatten Verschleißoberflächen führt, was wiederum zu niedrigen Reibkoeffizienten und hohen Standzeiten beim Einsatz der Verschleißoberfläche führt. Die Partikelgröße der pulverförmigen Härteträger liegt dabei typischerweise unter 10 µm. Besonders fein verteilte Karbide erhält man, indem während der Sinterung metallische Komponenten mit Kohlenstoff zur Reaktion gebracht werden, wie es im Fall von Mo- und NiCrhaltigen Spritzpulvern praktiziert wird.

Gesinterte und nachfolgend gebrochene Spritzpulver ("gesintert/gebrochene Spritzpulver") werden analog zu agglomeriert/gesinterten Spritzpulvern hergestellt, mit dem Unterschied, dass die Pulverkomponenten nicht zwingend nass in Dispersion vermischt werden, sondern trocken vermischt werden können und gegebenenfalls tablettiert oder zu Formkörpern kompaktiert werden. Die folgende Sinterung erfolgt analog, jedoch wird die Temperatur und/oder eine eventuelle Vorverdichtung so eingestellt, dass kompakte, feste Sinterkörper erhalten werden, welche durch mechanische Gewalteinwirkung wieder in Pulverform überführt werden müssen. Die erhaltenen Pulver sind daher von irregulärer Form und auf der Oberfläche von Bruchvorgängen gekennzeichnet. Sie haben typischerweise auch keine oder kaum innere Porosität, wie es im Fall der agglomeriert/gesinterten Spritzpulver typisch ist. Bild A.6 der DIN EN 1274 (Februar 2005) zeigt die typische Struktur gesintert/gebrochener Spritzpulver. Die Ausgangspulver sind kaum mehr zu erkennen. Diese Spritzpulver sind deutlich schlechter fließfähig, was für eine konstante Auftragsrate beim thermischen Spritzen nachteilig ist, jedoch oft noch praktikabel ist.
Sogenannte "gecladdete" Spritzpulver erhält man, wenn der pulverförmige Härteträger mittels galvanischer oder stromloser Abscheidung mit der metallischen Komponente beschichtet wird. Beispielsweise kann der Härteträger in pulverförmiger Form in einer Nickelsalz-Lösung dispergiert werden, worauf mittels elektrolytischer oder chemischer Reduktion eine wenige µm dicke Hülle auf ihm abgeschieden wird. Dieses Verfahren ist aber nur oberhalb einer Partikelgröße von etwa 10 µm des Härteträgers durchführbar, da sonst aufgrund der kleinen Krümmungsradien auf der Oberfläche des Härteträgers die notwendigen Keimbildungsenergien für die Neubildung der metallischen Phase zu stark ansteigen, und keine Hülle mehr erhalten wird. Die nach dem thermischen Spritzen erhaltenen Schichten enthalten daher relativ grobe Hartstoffteilchen und somit aus der Schichtoberfläche heraus ragende Härteträger, was für eine möglichst glatte Verschleißfläche unvorteilhaft ist. Bild A.2 der EN 1274 (Februar 2005) zeigt die typische Form eines mit Metall gecladdeten Hartstoffs.

Eine weitere Ausführungsform von Spritzpulvern aus mehreren verschiedenen Pulvern sind sogenannte "Blends". Diese stellen eine einfache Mischung von Pulvern dar, welche dann zur Beschichtung verwendet wird. Bei modernen Beschichtungsverfahren wie dem HVOF Verfahren kommt es jedoch aufgrund der hohen Strömungsgeschwindigkeit und den Turbulenzen meistens zu Entmischungen der Pulverkomponenten, so dass die Zusammensetzung der Schicht nicht mehr der Zusammensetzung des Blends entspricht.

Besonderes Interesse als Härteträger für Reibbeschichtungen rufen Nitride hervor. Sie weisen im Allgemeinen geringere Eigenhärten auf als die entsprechenden Karbide oder gar Boride, so TiN 2450 kg/mm² (zum Vergleich: TiC 3200 kg/mm²). Beispielsweise weisen Chromkarbide Eigenhärten zwischen 1880 kg/mm² (Cr₇C₃) und 1663 kg/mm² (Cr₂₃C₆) auf, dagegen hat Cr₂N 1591 kg/mm² und CrN lediglich 1093 kg/mm². Hieraus wird deutlich, warum reines CrN als Beschichtungswerkstoff für Kolbenringe etabliert ist. Während Cr₂N eine Eigenhärte in der Größenordnung von Chromkarbiden hat - und somit tribologisch für Reibpaarungen geeignet ist - weist CrN eine geringere Eigenhärte auf. Die bei PVD-Beschichtungen gemessenen weit höheren Härten sind durch Eigenspannungen und die besondere Unterstruktur der Beschichtung bedingt und dürfen nicht mit den Härten verglichen werden, welche an Kristalliten bestimmt werden ("Eigenhärten").

Zudem weisen Chromnitride eine hervorragende Beständigkeit gegenüber Reibverschleiß auf und sind aufgrund ihrer ausgeprägten chemischen Inertheit unempfindlich gegenüber Mikroverschweißungen, wie sie bei vielen Anwendungen wegen des resultierenden Adhäsionsverschleißes vermieden werden müssen.

Wünschenswert wären daher agglomeriert/gesinterte Spritzpulver mit einer metallischen Komponente wie beispielsweise Nickel, welche Chromnitride als Härteträger enthalten. Mit ihnen würden sich dickere Schichten herstellen lassen, welche genügend Verschleißreserven aufweisen würden.

Agglomeriert/gesinterte Spritzpulver oder gesintert/gebrochene Spritzpulver (im Rahmen dieser Offenbarung zusammenfassend als "gesinterte Spritzpulver" bezeichnet), insbesondere CrN enthaltend, sind bisher nicht bekannt geworden. Ursache ist, dass bei der Sinterung von Chromnitrid-haltigen Granulaten oder Pulvermischungen eine Zersetzung des CrN zu Cr₂N, von Cr₂N zu metallischem Chrom und - je nach Anwesenheit von Kohlenstoff bei der Sinterung - auch Weiterreaktion zu Cr-Karbiden eintritt, deren Eigenhärte allesamt höher liegen. Aufgrund der Schnelligkeit des Spritzprozesses und der im Vergleich zum Wärmetransport langsameren - infolge diffusiven Transports - Abspaltung des Stickstoffs ist davon auszugehen, dass gesinterte Spritzpulver auch Chromnitrid-haltige Beschichtungen erzeugen könnten, wenn man gesinterte Spritzpulver denn erzeugen könnte.

Aufgrund der hohen Schmelztemperaturen bei der Herstellung von verdüsten Spritzpulvern ist der zur Bildung von wesentlichen Gehalten an Chromnitriden notwendige Stickstoffgehalt nicht in der Schmelze zu erhalten, da deren Stickstofflöslichkeit zu gering ist.

Eine weitere Möglichkeit zur Herstellung von Chromnitrid-haltigen Beschichtungen ist die Verwendung von Pulvermischungen ("Blends"), beispielsweise Mischungen aus Ni- oder NiCr-Pulver einerseits, und Chromnitriden sowie ggf. anderen Härteträgern andererseits. Nachteilig ist jedoch, dass vergleichsweise grobe Härteträger verwendet werden müssen, damit deren Oxidation beim thermischen Spritzen genügend langsam ist, und genügend kinetische Energie beim Aufprallen vorhanden ist. Typische Partikelgrößen für Härteträger und Matrixmetall sind in diesem Fall 10 bis 100 µm. Derartig hergestellte Schichten weisen demnach hohe Rauhigkeiten und eine schlechte Verteilung von Härteträgern in der metallischen Matrix auf. Daher sind Blends keine Alternative.

DE 10 2008 056 720 B3 beschreibt die Herstellung einer Spritzschicht, welche als Gleitelement in einer Verbrennungskraftmaschine dient, aus Chromnitrid-haltigen Spritzpulvern, deren Herstellverfahren nicht offenbart ist. Die Gleitschicht hat eine Nominalzusammensetzung von 10 bis 30% Ni, 0,1 bis 5% Kohlenstoff, 10 bis 20% Stickstoff und 40 bis 79,9% Chrom. Das im Ausführungsbeispiel beschriebene Spritzpulver unbekannter Herstellweise hatte eine Nominalzusammensetzung von 60% CrN, 10% Cr₃C₂, 25% Ni und 5% Cr. Beschrieben ist die homogene Verteilung der Karbide (die im Spritzpulver enthaltenen 10% Cr₃C₂) in der Spritzschicht. Die Größe und Verteilung des CrN ist ebenfalls nicht offenbart. Das verwendete CrN führte in der Elementaranalyse lediglich zu 11 % Stickstoff statt der theoretisch zu erwartenden 12,72%. Es ist daher auszurechnen, dass es sich bei der als "CrN" beschriebenen Chromnitridkomponente nicht um reines CrN handeln kann, da sonst ein Stickstoffgehalt von 12,7% in der Elementanalyse zu erwarten wäre. Es ist anhand der angegebenen 11% Stickstoff zu errechnen, dass die im Spritzpulver zu 60% enthaltene Chromnitrid-Komponente lediglich zu 41%-Punkten aus CrN mit 21,2%N und zu 19%-Punkten aus Cr₂N mit 12,1% N bestand, d.h. sie bestand ihrerseits zu 68,3% aus CrN und zu 31,7% aus Cr₂N. Vermutlich daher wurden laut Offenbarung die Verschleißeigenschaften der CrN-PVD-Beschichtung nicht erreicht (Tabelle 1 der DE 10 2008 056 720 B3). Zudem enthält das offenbarte Pulver Chromkarbide, was anhand des offenbarten Materialsystems, der Mikrostrukturaufnahmen der Spritzschicht ("homogen verteilte Karbide") sowie der Elementanalyse kenntlich ist. Aufgrund der hohen Eigenhärte der Chromkarbide kann die Chromnitrid-basierte Gleitbeschichtung ihr volles Potential nicht zeigen und ist mit der mittels PVD hergestellten CrN-Beschichtung im Leistungsverhalten nicht vergleichbar. US 2012/082586 A1 offenbart ein Verfahren zum Nitrieren von Pulverpartikeln und zum Nitrieren von Oberflächen von festkörperartigen Teilen.

Aufgabe der vorliegenden Erfindung ist es, die vorgenannten Probleme des Standes der Technik zu lösen. Insbesondere war es Aufgabe der vorliegenden Erfindung, ein Verfahren zur Herstellung von Chromnitrid-haltigen, insbesondere CrN-haltigen, gesinterten Spritzpulvern bereitzustellen, welche über eine für den Spritzprozess erforderliche ausreichende Agglomeratfestigkeit verfügen.

Die vorliegende Erfindung wird definiert durch die beigefügten unabhängigen Ansprüche und deren abhängige Ansprüche.

Es wurde gefunden, dass eine Lösung für das Problem in der Herstellung eines Agglomerats aus Chrom oder CrN oder Cr₂N mit einer metallischen Binderlegierung sowie deren nachfolgende Sinterung in einer unter Überdruck stehenden Stickstoffatmosphäre besteht, bei welcher Cr zu Chromnitriden oder Cr₂N zu CrN reagieren kann oder die Chromnitride mindestens erhalten werden können.

Gegenstand der vorliegenden Erfindung ist ein Verfahren zur Herstellung Chromnitrid-haltiger gesinterter Spritzpulver gemäß Anspruch 1.

Soweit nicht anders angegeben, erfolgen die Prozentangaben in Gewichtsprozent.

Das erfindungsgemäße Verfahren zur Herstellung Chromnitrid-haltiger gesinterter Spritzpulver umfasst in einem ersten Schritt a) das Herstellen einer Pulvermischung (A), die ein Pulver (B) und ein Pulver (C) umfasst.

Das Pulver (B) umfasst ein oder mehrere Bestandteile, ausgewählt aus der Gruppe bestehend aus Chrom, CrN und Cr₂N. Besonders bevorzugt umfasst das Pulver (B) Mischungen aus CrN und Cr₂N. Das Gewichtsverhältnis von CrN zu Cr₂N kann in weiten Bereichen variieren, bevorzugt ist jedoch ein Gewichtsverhältnis von 1:100 bis 100:1, weiter bevorzugt, 1:10 bis 10:1, insbesondere 1:8 bis 1:1 und im Speziellen 1:6 bis 1:2.

In einer weiteren bevorzugten Ausführungsform umfasst das Pulver (B) Chromnitride (CrN und Cr₂N) in einer Menge von mindestens 70 Gew.-%, vorzugsweise mindestens 80 Gew.-%, weiter bevorzugt mindestens 90 Gew.-%, insbesondere mindestens 95 Gew.-% und im Speziellen besteht das Pulver (B) aus Chromnitriden.

Das Pulver (B) kann jedoch auch ausschließlich aus Chrom, oder auch aus CrN oder Cr₂N bestehen. Pulver B kann nicht nur durch Vermischen phasenreiner CrN- und Cr₂N-Pulver hergestellt werden, sondern auch durch ein mehrphasiges Pulver repräsentiert sein, welches in einem Pulverpartikel laut Röntgenbeugungsanalyse sowohl CrN als auch Cr₂N enthält. Zusätzlich kann ein solches mehrphasiges Pulver auch aus metallischem Chrom und Cr₂N bestehen, eventuell sogar metallisches Chrom, Cr₂N und CrN enthalten, eventuell auch weitere, noch nicht gefundene Chromnitride.

Insbesondere für Anwendungen, bei denen das mittels dem erfindungsgemäßen Verfahren erhaltene Spritzpulver für die Beschichtung von Reiboberflächen mit geringer Rauhigkeit eingesetzt werden soll, hat es sich als vorteilhaft herausgestellt, die Partikelgröße des Pulvers (B) möglichst klein zu wählen. In einer bevorzugten Ausführungsform weist daher das Pulver (B) eine Partikelgröße D50 unterhalb von 20 µm, weiter bevorzugt unterhalb von 15 µm auf. In einer besonderen Ausführungsform liegt der D50 Wert des Pulvers (B) zwischen 0,5 und 10 µm. Der D50 Wert bezieht sich dabei auf den volumetrischen Durchmesser und wird mittels Laserbeugung gemessen. D50 bedeutet, dass 50 % der Partikel Durchmesser besitzen, die kleiner sind als der angegebene Wert.

In einer weiteren bevorzugten Ausführungsform weist das Pulver (B) eine Partikelgröße D90 unterhalb von 20 µm, vorzugsweise unterhalb von 15 µm auf. In der vorliegenden Erfindung umfasst die Pulvermischung (A) das Pulver (B) in einer Menge von 50 bis 90 Gew.-%, vorzugsweise 60 bis 80 Gew.-%, jeweils bezogen auf das Gesamtgewicht der Pulvermischung (A).

Das Pulver (C) umfasst ein oder mehrere Bestandteile, ausgewählt aus der Gruppe bestehend aus Nickel, Kobalt, Nickellegierung (Legierungen, die Nickel enthalten, also insbesondere auch Nickel-Basislegierungen), Kobaltlegierung (Legierungen, die Kobalt enthalten, also insbesondere auch Kobalt-Basislegierungen) und Eisenlegierung (Legierungen, die Eisen enthalten, also insbesondere auch Eisen-Basislegierungen).

Das Pulver (C) dient als Metallmatrix (Bindemetall) für die Chromnitride, die als Hartstoffe wirken.

In einer bevorzugten Ausführungsform umfasst die Pulvermischung (A) eine Kobalt- oder Nickel- oder Eisen-Basislegierung. Die Basislegierung kann dabei einen oder mehrere Bestandteile enthalten, ausgewählt aus der Gruppe bestehend aus Cr, Si, Mo, Ti, Ta, B, Y, W, und Mn. Diese Bestandteile können gegebenenfalls bis zu 25 Gew.-% der Legierung ausmachen.

Gegebenenfalls, in Abhängigkeit von den gewählten Sinterbedingungen, können ein oder mehrere der vorgenannten Bestandteil(e) nitridiert werden.

In einer besonders bevorzugten Ausführungsform des erfindungsgemäßen Verfahrens umfasst die Pulvermischung (A) ein Nickelpulver und/oder ein NickelChrom-Legierungspulver.

Das Pulver (C) umfasst in der vorliegenden Erfindung ein oder mehrere Bestandteile, ausgewählt aus der Gruppe bestehend aus Nickel, Kobalt, Nickellegierung, Kobaltlegierung und Eisenlegierung in einer Menge von 50 Gew.-%, vorzugsweise 60 Gew.-%, weiter bevorzugt 75 Gew.-%, insbesondere 85 Gew.-% und speziell mindestens 95 Gew.-%, bezogen auf das Gesamtgewicht des Pulvers (C). In einer weiter bevorzugten Ausführungsform besteht das Pulver (C) aus einem oder mehreren Bestandteilen, die ausgewählt sind aus der Gruppe bestehend aus Nickel, Kobalt, Nickellegierung, Kobaltlegierung und Eisenlegierung.

Nickelpulver und Nickelbasislegierungspulver, beispielsweise Nickelchromlegierungspulver, haben sich als besonders geeignetes Metallmatrixmaterial für Chromnitrid-haltige gesinterte Spritzpulver herausgestellt, aber auch Co Pulver und Fe-Basislegierungen sind besonders geeignet, wenn sie mit Cr, Si, Mo und Mn legiert sind. In einer bevorzugten Ausführungsform der vorliegenden Erfindung enthält das Pulver (C) daher zu mindestens 50 Gew.-% ein Nickelpulver und/oder Nickelchromlegierungspulver, vorzugsweise zu mindestens 75 Gew.-%, weiter bevorzugt zu mindestens 95 Gew.-%, bezogen auf das Gesamtgewicht des Pulvers (C), insbesondere besteht das Pulver (C) aus einem Nickelpulver und/oder einem Nickelchromlegierungspulver. In der vorliegenden Erfindung weist die Pulvermischung (A) das Pulver (C) in einer Menge von 10 bis 50 Gew.-%, vorzugsweise 15 bis 45 Gew.-% und insbesondere von 20 bis 40 Gew.-%, jeweils bezogen auf das Gesamtgewicht der Pulvermischung (A) auf. Die Pulvermischung (A) umfasst vorteilhafterweise CrN und/oder Chrom und/oder Cr₂N sowie vorzugsweise ein Nickelpulver und/oder NickelchromLegierungspulver.

In einer weiteren bevorzugten Ausführungsform umfasst die Pulvermischung (A) eine Kobalt- oder Nickel- oder Eisenbasislegierung, wobei die Legierung gegebenenfalls ein oder mehrere Bestandteile enthält, insbesondere solche, ausgewählt aus der Gruppe bestehend aus Cr, Si, Mo, Ti, Ta, B, Y, W und Mn enthält.

Aufgrund ihrer Härte ist die Anwesenheit von Karbiden im gesinterten Spritzpulver möglichst gering zu halten. In der Pulvermischung (A) sollte somit der Kohlenstoffgehalt möglichst niedrig sein. In der vorliegenden Erfindung ist die Pulvermischung (A) im Wesentlichen frei von Kohlenstoff. Im Wesentlichen frei von Kohlenstoff im Rahmen der vorliegenden Erfindung bedeutet, dass die Menge des Kohlenstoffs in der Pulvermischung (A) unterhalb von 1 Gew.-%, vorzugsweise unterhalb von 0,1 Gew.-%, besonders bevorzugt unterhalb von 0,08% und insbesondere unterhalb von 0,05 Gew.-%, im Speziellen aber frei von Kohlenstoff ist, wobei die Gewichtsprozentangaben sich auf das Gesamtgewicht der Pulvermischung (A) beziehen.

In einer weiteren bevorzugten Ausführungsform ist die Pulvermischung (A) im Wesentlichen frei von Chromkarbiden. Im Wesentlichen frei von Chromkarbiden im Rahmen der vorliegenden Erfindung bedeutet, dass die Menge an Chromkarbiden unterhalb von 15 Gew.-%, vorzugsweise unterhalb von 1,5 Gew.-%, weiter bevorzugt unterhalb von 0,8 Gew.-%, insbesondere unterhalb von 0,2 Gew.- % und insbesondere frei von Chromkarbiden ist.

Die Herstellung der Pulvermischung (A) kann durch einfaches trockenes Vermischen der Pulver (B) und Pulver (C) erzielt werden. Üblicherweise erfolgt die Vermischung der Pulver in dazu dem Fachmann geläufigen Mischaggregaten, insbesondere Hochgeschwindigkeitsmischern mit hohen Scherkräften.

In einer bevorzugten Ausführungsform des erfindungsgemäßen Verfahrens erfolgt die Herstellung der Pulvermischung (A) durch Dispergieren der Pulver (B) und (C) zusammen in einer Flüssigkeit, wobei die Flüssigkeit nach erfolgter Durchmischung entfernt wird.

Als geeignete Flüssigkeiten haben sich hierzu insbesondere leichtsiedende Flüssigkeiten herausgestellt, insbesondere solche, ausgewählt aus der Gruppe bestehend aus Wasser, aliphatischen Alkoholen, Ketonen und beliebigen Mischungen hiervon. Speziell bevorzugt sind die Flüssigkeiten ausgewählt aus Wasser, Methanol, Ethanol und Propanol sowie Mischungen hiervon.

Das anschließende Entfernen der Flüssigkeit kann durch Verdampfen, vorzugsweise unter Anlegen eines verminderten Drucks erfolgen. In einer besonders bevorzugten Ausführungsform erfolgt die Entfernung der Flüssigkeit durch Sprühtrocknung, da am Ende des Verfahrens agglomeriert/gesinterte Spritzpulver erhalten werden.

In einer speziellen bevorzugten Ausführungsform kann die mit Flüssigkeit versetzte Dispersion zusätzlich einen temporären organischen Binder als Kleber aufweisen, der die Agglomeratbildung des Pulvers fördert und für eine mechanische Stabilität sorgt, die für die weitere Verarbeitung ausreichend ist. Geeignete temporäre organische Binder sind hier beispielsweise Polyvinylalkohol (PVA), Polyvinylpyrrolidon (PVP), Cellulosederivate, Polysacharide, Acrylsäurepolymere.

In Schritt b) des erfindungsgemäßen Verfahrens erfolgt das Festphasensintern der Pulvermischung (A), in einer Gasatmosphäre, die Stickstoff mit einem Partialdruck größer 1 bar enthält. Die Bedingungen des Festphasensinterns (insbesondere Stickstoffpartialdruck und Temperatur) werden erfindungsgemäß so gewählt, dass es zu einer Ausbildung oder Anreicherung oder Stabilisierung von Chromnitriden durch Stickstoffaufnahme während der Sinterung kommt. Somit kommt es im erfindungsgemäßen Verfahren nicht zu einem Verlust von chemisch gebundenem Stickstoff bei der Sinterung der Pulvermischung, sondern zu einer Erhöhung des chemisch gebundenen Stickstoffs, mindestens aber zu einem Erhalt des in der Pulvermischung vorhandenen, chemisch gebundenen Stickstoffs. Das Vorhandensein von Stickstoffgas mit einem Partialdruck > 1 bar in der Gasatmosphäre während der Sinterung ist essentiell für das erfindungsgemäße Verfahren der vorliegenden Erfindung. In der vorliegenden Erfindung weist die Gasatmosphäre mindestens 90 Vol.-%, vorzugsweise 95 Vol.-%, weiter bevorzugt mindestens 98 Vol.-% und insbesondere mindestens 99,5 Vol.-% Stickstoff, jeweils bezogen auf das Gesamtvolumen der Gasatmosphäre, auf. Die Anwesenheit von Sauerstoff ist nachteilig für den Verfahrensschritt der Festphasensinterung. Die Gegenwart von Sauerstoff führt zur Ausbildung von Oxiden, welche das Eigenschaftsprofil der Spritzpulver vermindern.

Es hat sich darüber hinaus herausgestellt, dass der Absolutdruck der Gasatmosphäre während der Festphasensinterung, einen erheblichen Einfluss auf die Ausbildung von Chromnitriden und hier speziell auf die Bildung von CrN nehmen kann. Vorzugsweise liegt der daher Absolutdruck der Gasatmosphäre oberhalb von 1 bar, beispielsweise oberhalb von 1,5 bar.

Besonders gute Ergebnisse konnten erzielt werden, wenn die Festphasensinterung bei einem Stickstoffpartialdruck oberhalb von 6 bar, vorzugsweise in einem Bereich von 7 bis 100 bar, weiter bevorzugt 8 bis 50 bar und insbesondere 9 bis 20 bar erfolgt. Je höher die Sintertemperatur, desto höher ist der erforderliche Mindestwert für den Stickstoffpartialdruck zu wählen.

Die Festphasensinterung wird üblicherweise bei Temperaturen durchgeführt, die die Ausbildung von Sinterhälsen in der Pulvermischung fördern. Diese Sinterhälse verleihen dem gesinterten Agglomerat genügend mechanische Festigkeit, wie es für das thermische Spritzen, insbesondere bei HVOF- und HVAF-Spritzprozessen, notwendig ist. Geeignet ist die Sinterung bei einer Temperatur oberhalb von 1000°C, vorzugsweise zwischen 1050°C und 1500°C, weiter bevorzugt zwischen 1100°C und 1350°C und insbesondere zwischen 1100°C und 1250°C.

Besonders bevorzugt wird die Festphasensinterung für einen Zeitraum und unter solchen Bedingungen durchgeführt, dass das gesinterte Spritzpulver Chromnitride aufweist, wobei die Menge des CrN mindestens 5 Gew.-%, vorzugsweise mindestens 20 Gew.-%, weiter bevorzugt mindestens 50 Gew.-% und insbesondere mindestens 80 Gew.-%, jeweils bezogen auf das Gesamtgewicht der beiden Chromnitride Cr₂N und CrN im gesinterten Spritzpulver, beträgt. Der Anteil der beiden Chromnitride wird dabei durch den Chromgehalt des Spritzpulvers und den Stickstoffgehalt des Spritzpulvers bestimmt, wobei ein denkbarer metallischer Chromanteil in der metallischen Matrix vernachlässigt wird.

Üblicherweise wird die Festphasensinterung über einen Zeitraum von mindestens 1 Stunde, vorzugsweise mindestens 2 Stunden, weiter bevorzugt mindestens 2,5 Stunden und insbesondere zwischen 3 und 48 Stunden durchgeführt. Längere Zeiten führen bei ansonsten gleichen Sinterbedingungen zu einer höheren Stickstoffaufnahme.

In einer besonders bevorzugten Ausführungsform der vorliegenden Erfindung umfasst das Verfahren zur Herstellung Chromnitrid-haltiger gesinterter Spritzpulver die folgenden Schritte:
a) Herstellen einer Pulvermischung (A) umfassend
   i) ein Pulver (B), umfassend Cr₂N Pulver und gegebenenfalls CrN, und
   ii) ein Pulver (C)
b) Sintern der Pulvermischung (A) in einer Gasatmosphäre, die mindestens 99,5 Vol.-% Stickstoff enthält, bei einem Druck der Gasatmosphäre oberhalb von 6 bar und Temperaturen zwischen 1050°C und 1400°C.

In einer weiteren, besonders bevorzugten Ausführungsform der vorliegenden Erfindung umfasst das Verfahren zur Herstellung CrN-haltiger gesinterter Spritzpulver die folgenden Schritte:
a) Herstellen einer Pulvermischung (A) umfassend
   i) ein Pulver (B), umfassend Chrompulver, und
   ii) ein Pulver (C)
b) Sintern der Pulvermischung (A) in einer Gasatmosphäre, die mindestens 99,5 Vol.-% Stickstoff enthält, bei einem Druck der Gasatmosphäre oberhalb von 6 bar und Temperaturen zwischen 1050°C und 1400°C.

Die durch das erfindungsgemäße Verfahren erhältlichen Chromnitrid-haltigen, gesinterten Spritzpulver weisen hervorragende Eigenschaften auf. Insbesondere ermöglicht das thermische Spritzverfahren die Ausbildung wesentlich dickerer Schichten.

Ein weiterer Gegenstand der vorliegenden Erfindung ist ein Chromnitrid-haltiges gesintertes Spritzpulver gemäß Anspruch 13, welches erhältlich ist durch das erfindungsgemäße Verfahren. Das Chromnitrid-haltige gesinterte Spritzpulver enthält bevorzugt Chromnitridpartikel mit einem mittleren Durchmesser von 1 bis 20 µm (z.B. elektrooptisch als Zahlenmittel bestimmt aus Bildauswertung (elektronen)mikroskopischer Aufnahmen, etwa als Jeffries-Durchmesser).

In einer weiteren bevorzugten Ausführungsform enthält das gesinterte Spritzpulver Chromnitrid, wobei CrN in einer Menge von mindestens 5 Gew.-%, vorzugsweise mindestens 20 Gew.-%, weiter bevorzugt mindestens 50 Gew.-% und insbesondere mindestens 80 Gew.-%, jeweils bezogen auf das Gesamtgewicht des Chromnitrids im gesinterten Spritzpulver, enthalten ist.

Die erfindungsgemäßen Chromnitrid-haltigen Spritzpulver eignen sich insbesondere zur Oberflächenbeschichtung von Bauteilen, beispielsweise Reibflächen.

Ein weiterer Gegenstand der vorliegenden Erfindung ist daher ein Verfahren zur Herstellung eines oberflächenbeschichteten Bauteils durch Beschichten eines Bauteils mittels thermischen Spritzens des erfindungsgemäßen Spritzpulvers gemäß Anspruch 14.

Das thermische Spritzen kann beispielsweise durch ein Hochgeschwindigkeits-Flammspritzen oder Plasmaspritzen erfolgen. Die durch das Beschichtungsverfahren erhältlichen Bauteile weisen extrem gute Reibeigenschaften und vor allem geringe Rauhigkeiten auf. Darüber hinaus kann durch das Spritzverfahren das Bauteil mit einer im Vergleich zu herkömmlich nach dem PVD herstellbaren Schichten dickeren Verschleißschicht versehen werden.

Ein weiterer Gegenstand der vorliegenden Erfindung ist daher die Verwendung des erfindungsgemäßen Spritzpulvers zur Oberflächenbeschichtung von Bauteilen gemäß Anspruch 15.

### Beispiele

### Beispiel 1 (Vergleichsbeispiel)

### (CrN+ Ni, Sinterung konventionell, Cr₂N-Bildung)

Es wurden 35 kg Chromnitrid mit 15,65 Gew.-% Stickstoff (bestehend aus CrN mit einem theoretischen Stickstoffgehalt von 21,2 Gew.-% und Cr₂N mit einem theoretischen Stickstoffgehalt von 12,1 Gew.-%) auf -10 µm Partikelgröße klassiert, zusammen mit 15 kg einer durch Verdüsen hergestellten Legierung NiCr 80/20 in Wasser dispergiert und sprühgetrocknet. Die erhaltenen Granalien wurden klassiert und bei 1000 °C in einem zur Sinterung von Spritzpulvern üblichen Durchschubofen in einem Kohlenstofftiegel bei einer Verweilzeit in der Heizzone von 3h und 12 min gesintert. Die Ofenatmosphäre hatte einen Druck von wenigen Millibar über Atmosphärendruck und bestand im Wesentlichen aus Wasserstoff. Erhalten wurde ein agglomeriert/gesintertes Spritzpulver mit folgenden Eigenschaften:

**Tabelle 1**

| Element (Messgröße) (% -Werte sind als Gewichtsprozente zu verstehen) | Messwert | Messmethode |
|---|---|---|
| Nickel (%) | 23,7 | |
| Stickstoff (%) | 7,2 | |
| Sauerstoff (%) | 0,64 | |
| Kohlenstoff (%) | 0,58 | |
| Mittlere Partikelgröße (µm) | 31 | Microtrac S3500 |

Der zu erwartende Wert für den Stickstoffgehalt im Spritzpulver läge bei 70 Gewichtsprozent des Stickstoffgehaltes des eingesetzten Chromnitrides (= 10,95 Gewichtsprozent im Spritzpulver), wenn keine Zersetzung des eingesetzten Chromnitrides stattfinden würde. Tatsächlich liegt der Wert aber sogar unter dem Erwartungswert beim vollständigen Vorliegen des Chromnitrides als Cr₂N (= 70% von 12.1% = 8,47%), was darauf hindeutet, dass hauptsächlich Cr₂N vorliegt und sich zusätzlich Chromkarbide gebildet haben (es wurden beim Sintern 0,58 Gew.-% Kohlenstoff aufgenommen). Folgerichtig wurde mittels Röntgenbeugung neben der NiCr-Phase nur Cr₂N nachgewiesen und kein CrN. Bei der konventionellen Sinterung von agglomeriert/gesinterten Spritzpulvern ist also mit Zersetzung der Chromnitride, insbesondere des besonders erwünschten CrN, zu Cr₂N und Chromkarbiden zu rechnen.

### Beispiel 2 (Vergleichsbeispiel, teilweise erfindungsgemäß = *)

Analog zu Beispiel 1 wurde ein Sprühgranulat aus 70 Gew.-% Chromnitrid-Pulver mit einem Stickstoffgehalt von 11,87 Gew.-% (im Wesentlichen bestehend aus Cr₂N), und 30 Gew.-% NiCr 80/20 verdüstem Legierungspulver hergestellt. Dieses Sprühgranulat wurde bei verschiedenen Kombinationen von Sintertemperatur und Stickstoffpartialdruck für 3 Stunden in einem Drucksinterofen in einem Kohlenstofftiegel gesintert, unter gleichem Druck auf Raumtemperatur abgekühlt, und der Stickstoffgehalt der jeweils erhaltenen Spritzpulver bestimmt. Der aus der Rezeptur errechnende Stickstoffgehalt für das Ausgangsprodukt beträgt 8,31%.

**Tabelle 2**

| Temperatur (°C) | Stickstoffdruck (bar) | Stickstoff (Gew.-%) | Chromnitrid-Phasen laut Röntgenbeugung |
|---|---|---|---|
| 1300 | 5 | 7,64 | Cr₂N, wenig CrN |
| 1300 | 7* | 12,50 | Cr₂N, CrN |
| 1300 | 10* | 13,60 | Wenig Cr₂N, CrN |
| 1200 | 10* | 13,70 | CrN |

Es wird deutlich, dass bei gegebener Temperatur in Abhängigkeit vom Stickstoffdruck Verlust oder Zugewinn des Stickstoffgehaltes stattfindet und sich somit durch geeignete Wahl der Parameter Druck und Temperatur der Anteil an Cr₂N-Phase verringern lässt, während der Anteil an besonders erwünschter CrN-Phase zunimmt. Der Anteil des CrN in der Chromnitridkomponente lässt sich nicht genau errechnen, da damit zu rechnen ist, dass das im NiCr enthaltene Cr in unbekanntem Umfang ebenfalls Chromnitride gebildet hat. Unter Vernachlässigung dieses Effektes errechnet sich jedoch bei 1200°C/10 bar Stickstoffdruck ein Anteil von 82% CrN in der Chromnitrid-Komponente.

Erhalten wurde in allen Fällen ein versinterter Kuchen, der nur unter mechanischer Gewalteinwirkung wieder in ein gesintert/gebrochenes Spritzpulver zu überführen war.

### Beispiel 3 (erfindungsgemäß)

Aus 60% Chromnitrid-Pulver mit einem Stickstoffgehalt von 14,7% (entsprechend einem CrN-Anteil von etwa 29%) und einem Kohlenstoffgehalt von 0,05% sowie 40% feinteiligem Nickel-Pulver (Vale-INCO, Typ T255) wurde eine Dispersion in Wasser und daraus ein Sprühgranulat hergestellt. Dieses wurde bei 1150°C bei 11 bar Stickstoffdruck für 3 Stunden in einem Drucksinterofen gesintert, und der Gehalt an Stickstoff im agglomeriert/gesinterten Spritzpulver bestimmt. Der aus der Rezeptur zu errechnende Stickstoffgehalt des Sprühgranulates beträgt 8,82%.

**Tabelle 3**

| Temperatur (°C) | Stickstoffdruck (bar) | Stickstoff (Gew.-%) | Chromnitrid-Phasen laut Röntgenbeugung |
|---|---|---|---|
| 1150 | 11 | 11,6 | CrN, Spuren Cr₂N |

**Tabelle 4**

| Element (Messgröße) (% -Werte sind als Gewichtsprozente zu verstehen) | Messwert | Messmethode |
|---|---|---|
| Nickel (%) | 40,4 | |
| Stickstoff (%) | 11,5 | |
| Sauerstoff (%) | 0,53 | |
| Kohlenstoff (%) | 0,19 | |
| Hall Flow (s/50g) | 30 | ASTM B-212 |
| Mittlere Partikelgröße (µm) | 38 | Microtrac S3500 |
| Apparent Density (g/cm3) | 2,75 | ASTM B-213 |

Das erhaltene agglomeriert/gesinterte Spritzpulver ließ sich leicht durch eine Absiebung in die für HVOF-Spritzprozesse geforderte Partikelgrößenklasse von 45 bis 15 µm zerkleinern, da das Sintergut nur sehr locker versintert war. Die einzelnen, bei der Sprühtrocknung entstandenen Granulate waren ihrerseits von ausreichender Festigkeit für das thermische Spritzen.
Am Gehalt für den Stickstoff ist zu erkennen, dass während der Sinterung zusätzlicher Stickstoff chemisch gebunden wurde. Unter Berücksichtigung der theoretischen Stickstoffgehalte liegt der Anteil des CrN in der Chromnitrid-Komponente bei 79 Gew.-%, und bei 21 Gew.-% für das Cr₂N. Besonders vorteilhaft ist der im Vergleich zu Beispiel 1 geringere Kohlenstoffgehalt bzw. Chromkarbidgehalt.

### Beispiel 4 (erfindungsgemäß)

Aus 75 Gew.-% Chromnitrid-Pulver mit einem Stickstoffgehalt von 14,7 Gew.-% (entsprechend einem CrN-Anteil von etwa 29 Gew.-%) und einem Kohlenstoffgehalt von <0,08 Gew.-% sowie 25% feinteiligem Kobalt-Pulver wurde eine Dispersion in Wasser und daraus ein Sprühgranulat hergestellt. Dieses wurde bei 1150°C bei 11 bar Stickstoffdruck für 3 Stunden in einem Drucksinterofen gesintert, und der Gehalt an Stickstoff im Spritzpulver bestimmt. Der aus der Rezeptur zu errechnende Stickstoffgehalt des Sprühgranulates beträgt 11,0 Gew.-%.

**Tabelle 5**

| Element (Messgröße) (% -Werte sind als Gewichtsprozente zu verstehen) | Messwert | Messmethode |
|---|---|---|
| Kobalt (%) | 22,9 | |
| Stickstoff (%) | 14,9 | |
| Sauerstoff (%) | 0,7 | |
| Kohlenstoff (%) | 0,32 | |
| Hall Flow (s/50g) | 35 | ASTM B-212 |
| Mittlere Partikelgröße (µm) | 34 | Microtrac S3500 |
| Apparent Density (g/cm3) | 2,3 | ASTM B-213 |

Das erhaltene agglomeriert/gesinterte Spritzpulver ließ sich leicht durch eine Absiebung in die geforderte Partikelgrößenklasse von 45 bis 15 µm zerkleinern, da das Sintergut nur sehr locker versintert war. Die einzelnen, bei der Sprühtrocknung entstandenen Granulate waren ihrerseits von ausreichender Festigkeit für das thermische Spritzen.

## Patentansprüche

1. Verfahren zur Herstellung Chromnitrid-haltiger gesinterter Spritzpulver umfassend die folgenden Schritte:
a) Herstellen einer Pulvermischung (A) umfassend
i) ein Pulver (B) umfassend ein oder mehrere Bestandteile, ausgewählt aus der Gruppe bestehend aus Cr, CrN und Cr₂N, und
ii) ein Pulver (C) umfassend ein oder mehrere Bestandteile, ausgewählt aus der Gruppe bestehend aus Nickel, Kobalt, Nickellegierung, Kobaltlegierung und Eisenlegierung in einer Menge von mindestens 50 Gew.-% bezogen auf das Gesamtgewicht des Pulvers (C), wobei das Pulver (C) als Bindemetall dient,
b) Festphasensintern der Pulvermischung (A) in einer Gasatmosphäre, die bezogen auf das Gesamtvolumen der Atmosphäre mindestens 90 Vol.-% Stickstoff aufweist, bei einem Stickstoffpartialdruck von größer 1 bar, unter Erhaltung oder Zunahme des chemisch gebundenen Stickstoffs gegenüber der Pulvermischung (A),
wobei die Pulvermischung (A) das Pulver (B) in einer Menge von 50 bis 90 Gew.-%, das Pulver (C) in einer Menge von 10 bis 50 Gew.-% und Kohlenstoff in einer Menge unterhalb von 1 Gew.-%, jeweils bezogen auf das Gesamtgewicht der Pulvermischung (A), enthält.

2. Verfahren gemäß Anspruch 1, **dadurch gekennzeichnet, dass** die Pulvermischung (A) ein Nickelpulver und/oder NiCr-Legierungspulver, vorzugsweise eine Kobalt- oder Nickel- oder Eisenbasislegierung enthält, wobei die Legierung gegebenenfalls ein oder mehrere Bestandteile, ausgewählt aus der Gruppe bestehend aus Cr, Si, Mo, Ti, Ta, B, Y, W, und Mn enthält.

3. Verfahren gemäß einem oder mehreren der Ansprüche 1 oder 2, **dadurch gekennzeichnet, dass** die Herstellung der Pulvermischung (A) durch Dispergieren des Pulvers (B) mit dem Pulver (C) in einer Flüssigkeit erfolgt, wobei die Flüssigkeit nach erfolgtem Durchmischen entfernt wird.

4. Verfahren gemäß einem oder mehreren der Ansprüche 1 bis 3, **dadurch gekennzeichnet, dass** das Pulver (B) eine Partikelgröße D90 unterhalb von 20 µm, vorzugsweise unterhalb von 15 µm, gemessen mittels Laserbeugung, aufweist.

5. Verfahren gemäß einem oder mehreren der Ansprüche 1 bis 4, **dadurch gekennzeichnet, dass** die Festphasensinterung in einer Gasatmosphäre erfolgt, die mindestens 95 Vol.-%, bevorzugt mindestens 98 Vol.-% und insbesondere mindestens 99,5 Vol.-% Stickstoff aufweist, jeweils bezogen auf das Gesamtvolumen der Atmosphäre.

6. Verfahren gemäß einem oder mehreren der Ansprüche 1 bis 5, **dadurch gekennzeichnet, dass** die Festphasensinterung bei einem StickstoffpartialDruck oberhalb von 6 bar, vorzugsweise in einem Bereich von 7 bis 100 bar, weiter bevorzugt 8 bis 50 bar und insbesondere 9 bis 20 bar erfolgt.

7. Verfahren gemäß einem oder mehreren der Ansprüche 1 bis 6, **dadurch gekennzeichnet, dass** die Festphasensinterung bei einer Temperatur oberhalb von 1000°C, vorzugsweise zwischen 1050°C und 1500°C, weiter bevorzugt zwischen 1100°C und 1350°C und insbesondere zwischen 1100°C und 1250°C erfolgt, und/oder
über einen Zeitraum von mindestens 1 Stunde, vorzugsweise mindestens 2 Stunden, weiter bevorzugt mindestens 2,5 Stunden und insbesondere zwischen 3 und 48 Stunden erfolgt.

8. Verfahren gemäß einem oder mehreren der Ansprüche 1 bis 7, **dadurch gekennzeichnet, dass** die Pulvermischung (A) im Wesentlichen frei von Chromkarbiden ist.

9. Verfahren gemäß einem oder mehreren der Ansprüche 1 bis 8, **dadurch gekennzeichnet, dass** die Pulvermischung (A) das Pulver (B) in einer Menge von 60 bis 80 Gew.-%, bezogen auf das Gesamtgewicht der Pulvermischung (A), enthält.

10. Verfahren gemäß einem oder mehreren der Ansprüche 1 bis 9, **dadurch gekennzeichnet, dass** die Pulvermischung (A) das Pulver (C) in einer Menge von 15 bis 45 Gew.-%, vorzugsweise von 20 bis 40 Gew.-%, jeweils bezogen auf das Gesamtgewicht der Pulvermischung (A), enthält.

11. Verfahren gemäß einem oder mehreren der Ansprüche 1 bis 10, **dadurch gekennzeichnet, dass** das gesinterte Spritzpulver Chromnitride aufweist, wobei die Menge des CrN mindestens 50 Gew.-%, vorzugsweise mindestens 75 Gew.-%, weiter bevorzugt mindestens 78 Gew.-% und insbesondere mindestens 80 Gew.-%, jeweils bezogen auf das Gesamtgewicht des Chromnitrids im gesinterten Spritzpulver, enthält.

12. Verfahren gemäß einem oder mehreren der Ansprüche 1 bis 11, **dadurch gekennzeichnet, dass** die Pulvermischung (A) Kohlenstoff in einer Menge unterhalb von 0,1 Gew.-%, vorzugsweise unterhalb von 0,08 Gew.-%, besonders bevorzugt unterhalb von 0,05 Gew.-%, jeweils bezogen auf das Gesamtgewicht der Pulvermischung (A), enthält, und insbesondere frei von Kohlenstoff ist.

13. Chromnitrid-haltiges gesintertes Spritzpulver, erhältlich durch ein Verfahren gemäß einem oder mehreren der Ansprüche 1 bis 12.

14. Verfahren zur Herstellung eines oberflächenbeschichteten Bauteils durch thermisches Spritzen eines Bauteils mittels Spritzpulver gemäß Anspruch 13.

15. Verwendung des Spritzpulvers gemäß Anspruch 13 zur Oberflächenbeschichtung von Bauteilen.

## Claims

1. Method for producing chromium-nitride-containing sintered spray powders, comprising the following steps:
a) preparing a powder mixture (A) comprising
i) a powder (B) comprising one or more constituents selected from the group consisting of Cr, CrN, and Cr₂N, and
ii) a powder (C) comprising one or more constituents selected from the group consisting of nickel, cobalt, nickel alloy, cobalt alloy, and iron alloy in an amount of at least 50 wt%, relative to the total weight of the powder (C), wherein the powder (C) serves as binder metal,
b) solid-phase sintering of the powder mixture (A) in a gas atmosphere, which comprises at least 90 vol% nitrogen relative to the total volume of the atmosphere, at a nitrogen partial pressure greater than 1 bar, while maintaining or increasing the chemically-bound nitrogen with respect to the powder mixture (A),
wherein the powder mixture (A) contains the powder (B) in an amount of 50 to 90 wt%, the powder (C) in an amount of 10 to 50 wt%, and carbon in an amount below 1 wt%, in each case relative to the total weight of the powder mixture (A).

2. Method according to claim 1, **characterized in that** the powder mixture (A) contains a nickel powder and/or NiCr alloy powder - preferably, a cobalt-, nickel-, or iron-based alloy - wherein the alloy optionally contains one or more constituents selected from the group consisting of Cr, Si, Mo, Ti, Ta, B, Y, W, and Mn.

3. Method according to one or more of claims 1 or 2, **characterized in that** the production of the powder mixture (A) is effected by dispersing the powder (B) with the powder (C) in a liquid, wherein the liquid is removed after thorough mixing.

4. Method according to one or more of claims 1 through 3, **characterized in that** the powder (B) has a particle size D90 below 20 µm - preferably, below 15 µm - measured by means of laser diffraction.

5. Method according to one or more of claims 1 through 4, **characterized in that** the solid phase sintering takes place in a gas atmosphere having at least 95 vol% - preferably, at least 98 vol%, and, in particular, at least 99.5 vol% - nitrogen, in each case relative to the total volume of the atmosphere.

6. Method according to one of claims 1 through 5, **characterized in that** the solid phase sintering is carried out at a nitrogen partial pressure above 6 bar - preferably, in a range of 7 to 100 bar, more preferably, of 8 to 50 bar, and, in particular, of 9 to 20 bar.

7. Method according to one of claims 1 through 6, **characterized in that** the solid phase sintering is carried out at a temperature above 1,000°C - preferably, between 1,050°C and 1,500°C, more preferably, between 1,100°C and 1,350°C, and, in particular, between 1,100°C and 1,250°C, and/or
is carried out over a period of at least 1 hour -preferably, at least 2 hours, more preferably, at least 2.5 hours, and, in particular, between 3 and 48 hours.

8. Method according to one of claims 1 through 7, **characterized in that** the powder mixture (A) is substantially free of chromium carbides.

9. Method according to one of claims 1 through 8, **characterized in that** the powder mixture (A) contains the powder (B) in an amount of 60 to 80 wt%, relative to the total weight of the powder mixture (A).

10. Method according to one of claims 1 through 9, **characterized in that** the powder mixture (A) contains the powder (C) in an amount of 15 to 45 wt% - preferably, of 20 to 40 wt% - in each case relative to the total weight of the powder mixture (A).

11. Method according to one or more of claims 1 through 10, **characterized in that** the sintered spray powder has chromium nitrides, wherein the amount of CrN is at least 50 wt% - preferably, at least 75 wt%, more preferably, at least 78 wt%, and, in particular, at least 80 wt% - in each case relative to the total weight of the chromium nitride in the sintered spray powder.

12. Method according to one or more of claims 1 through 11, **characterized in that** the powder mixture (A) contains carbon in an amount below 0.1 wt% - preferably, below 0.08 wt%, and, particularly preferably, below 0.05 wt% - in each case relative to the total weight of the powder mixture (A), and, in particular, is free of carbon.

13. Chromium-nitride-containing sintered spray powder obtainable by a process according to one or more of claims 1 through 12.

14. Method for producing a surface-coated component by thermal spraying of a component by means of spray powder according to claim 13.

15. Use of the spray powder according to claim 13 for the surface coating of components.

## Revendications

1. Procédé de fabrication d'une poudre de pulvérisation frittée contenant du nitrure de chrome, comprenant les étapes suivantes :
a) fabrication d'un mélange de poudres (A) comprenant
i) une poudre (B) comprenant un ou plusieurs composants, choisis dans le groupe consistant en Cr, CrN et Cr₂N et
ii) une poudre (C) comprenant un ou plusieurs composants, choisis dans le groupe consistant en le nickel, le cobalt, un alliage de nickel, un alliage de cobalt et un alliage de fer en une quantité d'au moins 50 % en poids par rapport au poids total de la poudre (C), la poudre (C) servant de liant métallique,
b) frittage en phase solide du mélange de poudres (A) dans une atmosphère gazeuse, qui comporte au moins 90 %en volume d'azote par rapport au volume total de l'atmosphère, à une pression partielle de l'azote supérieure à 1 bar, de manière à conserver ou augmenter l'azote chimiquement lié par rapport au mélange de poudres (A),
le mélange de poudres (A) contenant la poudre (B) en une quantité de 50 à 90 % en poids, la poudre (C) en une quantité de 10 à 50 % en poids et du carbone en une quantité inférieure à 1 % en poids, respectivement par rapport au poids total du mélange de poudres (A).

2. Procédé selon la revendication 1, **caractérisé en ce que** le mélange de poudres (A) contient une poudre de nickel et/ou une poudre d'alliage NiCr, de préférence un alliage à base de cobalt, de nickel ou de fer, l'alliage contenant le cas échéant un ou plusieurs composants, choisis dans le groupe consistant en Cr, Si, Mo, Ti, Ta, B, Y, W et Mn.

3. Procédé selon une ou plusieurs des revendications 1 et 2, **caractérisé en ce que** la fabrication du mélange de poudres (A) est effectuée par dispersion de la poudre (B) avec la poudre (C) dans un liquide, le liquide étant éliminé une fois le mélange effectué.

4. Procédé selon une ou plusieurs des revendications 1 à 3, **caractérisé en ce que** la poudre (B) présente une taille de particule D90 inférieure à 20 µm, de préférence inférieure à 15 µm, mesurée par diffraction laser.

5. Procédé selon une ou plusieurs des revendications 1 à 4, **caractérisé en ce que** le frittage en phase solide est effectué dans une atmosphère gazeuse, qui comporte au moins 95 % en volume, de préférence au moins 98 % en volume et en particulier au moins 99,5 %en volume d'azote, respectivement par rapport au volume total de l'atmosphère.

6. Procédé selon une ou plusieurs des revendications 1 à 5, **caractérisé en ce que** le frittage en phase solide est effectué à une pression partielle de l'azote supérieure à 6 bar, de préférence comprise dans une plage de 7 à 100 bar, plus préférentiellement de 8 à 50 bar et en particulier de 9 à 20 bar.

7. Procédé selon une ou plusieurs des revendications 1 à 6, **caractérisé en ce que** le frittage en phase solide est effectué à une température supérieure à 1000 °C, de préférence comprise entre 1050 °C et 1500 °C, plus préférentiellement entre 1100 °C et 1350 °C et en particulier entre 1100 °C et 1250 °C et/ou
est effectué pendant une durée d'au moins 1 heure, de préférence au moins 2 heures, plus préférentiellement au moins 2,5 heures et en particulier entre 3 et 48 heures.

8. Procédé selon une ou plusieurs des revendications 1 à 7, **caractérisé en ce que** le mélange de poudres (A) est essentiellement dépourvu de carbures de chrome.

9. Procédé selon une ou plusieurs des revendications 1 à 8, **caractérisé en ce que** le mélange de poudres (A) contient la poudre (B) en une quantité de 60 à 80 % en poids, par rapport au poids total du mélange de poudres (A).

10. Procédé selon une ou plusieurs des revendications 1 à 9, **caractérisé en ce que** le mélange de poudres (A) contient la poudre (C) en une quantité de 15 à 45 % en poids, de préférence de 20 à 40 % en poids, respectivement par rapport au poids total du mélange de poudres (A).

11. Procédé selon une ou plusieurs des revendications 1 à 10, **caractérisé en ce que** la poudre de pulvérisation frittée comporte du nitrure de chrome, la quantité du CrN étant d'au moins 50 % en poids, de préférence au moins 75 % en poids, plus préférentiellement au moins 78 % en poids et en particulier au moins 80 % en poids, respectivement par rapport au poids total du nitrure de chrome dans la poudre de pulvérisation frittée.

12. Procédé selon une ou plusieurs des revendications 1 à 11, **caractérisé en ce que** le mélange de poudres (A) contient du carbone en une quantité inférieure à 0,1 % en poids, de préférence inférieure à 0,08 % en poids, de préférence encore inférieure à 0,05 % en poids, respectivement par rapport au poids total du mélange de poudres (A) et il est en particulier dépourvu de carbone.

13. Poudre de pulvérisation frittée contenant du nitrure de chrome, pouvant être obtenue par un procédé selon une ou plusieurs des revendications 1 à 12.

14. Procédé pour la fabrication d'un composant doté d'un revêtement de surface, par pulvérisation à chaud d'un composant au moyen de poudre de pulvérisation selon la revendication 13.

15. Utilisation de la poudre de pulvérisation selon la revendication 13 pour le revêtement de surface de composants.
